# EUROPEAN PATENT APPLICATION

(11) **EP 4 722 412 A1**
(43) Date of publication of application: **08.04.2026**
(21) Application number: 24204716.5
(22) Date of filing: 04.10.2024
(51) Int. Cl.: C23C 16/455, C23C 16/458, C23C 16/50, H01J 37/32, H01L 21/687

(54) **SPATIAL ATOMIC LAYER DEPOSITION DEVICE AND A METHOD FOR COATING A SUBSTRATE**

(71) Applicant: Bühler Alzenau GmbH, 63755 Alzenau (DE)
(72) Inventor: Thakur, Abhishekkumar, 63755 Alzenau (DE); Holopainen, Jani, 63755 Alzenau (DE); Mingels, Stephan, 63755 Alzenau (DE); Karthikeyan, Gurumani, 63755 Alzenau (DE)
(74) Representative: Prinz & Partner mbB

(57) **Abstract**

A spatial atomic layer deposition device (10) for coating substrates (20) comprises a rotatable turntable (12) having at least one receptacle (18) for a substrate (20), wherein the receptacle (18) extends through the turntable (12) such that a substrate (20) arranged in the receptacle (18) is accessible from above and below, at least one pair of gas processing assemblies (32, 34), wherein a first gas processing assembly (32) of the pair of gas processing assemblies (32, 34) is arranged above the turntable (12) and a second gas processing assembly (34) of the pair of gas processing assemblies (32, 34) is arranged below the turntable (12) in overlap with the first gas processing assembly (32). The at least one pair of gas processing assemblies (32, 34) is arranged at the same radial position as the receptacle (18) with respect to a rotation axis of the turntable (12), thereby forming a gas reaction station (26), and the gas processing assemblies (32, 34) each comprise at least one gas inlet port (54, 55) for exposing the substrate (20) with a gas within the gas reaction station (26).

Further, a system comprising such a deposition device and a method for coating a substrate is given.

## Description

The invention relates to a spatial atomic layer deposition device, a system with such a device and a method for coating a substrate in a deposition device.

Atomic layer deposition, ALD, is a technique for depositing thin films on a given substrate based on gaseous precursors and/or co-reactants undergoing chemical processes for forming a coating on the substrate. In ALD, a first precursor is dosed onto the substrate, wherein the precursor reacts with the substrate in a self-limiting manner such that an atomic layer is formed on the substrate. In a subsequent step, a second precursor or co-reactant is dosed onto the substrate, wherein the second precursor reacts with the previously formed atomic layer. The energy necessary to drive the reaction of the second precursor or co-reactant is typically provided in the form of substrate heating. Then, the cycle or run is repeated, thus providing a very controlled deposition procedure, as the two different precursors are not present at the same time to avoid unwanted cross-reactions.

In a further variant called plasma-assisted ALD, instead of providing the energy required to drive the reaction of the second precursor or co-reactant by heating, a plasma is generated out of the second precursor or co-reactant to drive the reaction of the atomic layer formed from the precursor to form the desired chemical species on the substrate.

Though ALD provides a way to produce coated substrates in a very controlled manner, ALD suffers from a low overall deposition rate of the coating due to the cyclic nature of the respective steps of an ALD cycle and due to only one atomic layer growth of the targeted material per cycle. To achieve higher deposition rates, a further variant termed spatial ALD, s-ALD, has been developed, in which the separate precursor or co-reactant application steps or the precursor application and plasma application steps take place at different locations within the deposition device and are thus separated in space. This spatial separation can be realized by placing the substrate in a receptacle of a holder and providing a linear arrangement of application stations, wherein the substrate is moved from one application station to the other due to a linear movement of the holder. Alternatively, a rotatable turntable is used as holder and the substrate is moved from one application station to the other due to a rotational movement of the turntable. Spatial ALD makes it possible to realize production lines with an overall increased throughput compared to conventional ALD processes.

However, there still remains a need for further increasing the deposition rate for spatial ALD processes while retaining a high level of conformity in the obtained coating. This is especially important in application scenarios in which the substrate is to be coated on more than one side surface, which makes it necessary to run several ALD processes one after each other, wherein the substrate is flipped between subsequent ALD processes to expose another surface of the substrate to the precursors.

It is therefore an object of the invention to provide a spatial ALD deposition device and system which provides high deposition rates and uniform coatings on substrates, especially for applying uniform coatings covering the substrate on several surfaces or all around. It is a further object of the invention to provide a spatial ALD method for coating a substrate.

The object of the invention is solved by a spatial atomic layer deposition, sALD, device for coating substrates, the deposition device comprising a rotatable turntable having at least one receptacle for a substrate, wherein the receptacle extends through the turntable such that a substrate arranged in the receptacle is accessible from above and below. The device further comprises at least one pair of gas processing assemblies, wherein a first gas processing assembly of the pair of gas processing assemblies is arranged above the turntable and a second gas processing assembly of the pair of gas processing assemblies is arranged below the turntable in overlap with the first gas processing assembly. The at least one pair of gas processing assemblies is arranged at the same radial position as the receptacle with respect to a rotation axis of the turntable, thereby forming a gas reaction station. The gas processing assemblies each comprise at least one gas inlet port for exposing the substrate with a gas within the gas reaction station.

The turntable can comprise a plurality of receptacles which are distributed at different radial positions along the turntable. The expression "at different radial positions" here denotes that the receptacles are arranged on a circle with a fixed radius to the center of the turntable. The plurality of receptacles especially are evenly distributed around the turntable. This allows to place multiple substrates at once in the turntable, such that the multiple substrates can be rotated to different stations of the deposition device in parallel, thereby further increasing the output of the deposition device.

The receptacle(s) can be designed such to place the substrate(s) anywhere along the thickness of the turntable to allow for an even better adaptability to the size of a given substrate to be coated. That is, the receptacle(s) can be designed such that the substrate(s) are held at an optimal position along the axial direction defined by the turntable.

As the skilled person will understand, the receptacle(s) include a means for securing the substrate within the receptacle. E.g., the substrate can be held within the receptacle on a nose, lug or rim of the receptacle. Of course, the size of a contact surface of the substrate being in contact with the means for securing the substrate within the receptacle should be as small as possible, as the substrate cannot be coated on the contact surface. Thus, the skilled person will understand that when in the following it is referred to a coating applied all-around the substrate or at all surfaces of the substrate, said coating will not include a coating on the contact surface of the substrate.

Still, the deposition device according to the invention increases the coverage rate of the coating on the surface of the substrate compared to deposition devices in which the substrate must be flipped for coating the backside of the substrate, as in such conventional deposition devices for each coating step an uncoated edge area will be obtained in the part of the substrate which is used for handling and/or holding the substrate.

The receptacle can further be configured to be able to rotate the substrate within the receptacle. This allows to further increase the uniformity of the coating, as longer exposure times for parts of the substrate which are less accessible can be realized.

The gas processing assemblies, i.e. the first gas processing assembly and the second gas processing assembly, may be configured as showerheads with one or more gas nozzles for applying the gas onto the substrate.

It is also possible that the first gas processing assembly and the second gas processing assembly comprise multiple individual showerheads.

During operation of the device, the position of the gas processing assemblies in relation to each other remains the same even when the turntable is rotated. This ensures that, during rotation, the receptacle passing the gas processing assemblies will always be appropriately placed in the gas processing station such that the substrate held in the receptacle is reliably exposed to the gas emitted by the respective gas processing assembly.

The invention is based on the idea to equip the turntable, which is used for moving the substrate between different stations for conducting the subsequent ALD steps of an ALD cycle, with a receptacle that extends through the turntable. In this way, the substrate is accessible by the reactive species from more than one side at the same time. By further providing the deposition device with at least one gas reaction station having a pair of gas processing assemblies associated to the top and the bottom of the turntable, respectively, both the upper side and the lower side of a substrate kept within the receptacle can be exposed to the gas, which comprises e.g. a precursor, at the same time such to provide for a growth of the coating on several surfaces of the substrate at once or even on all surfaces of the substrate. This increases the achievable throughput of the deposition device, i.e. the number of substrates which can be coated in a given unit time.

Also, this allows to achieve a higher throughput compared to conventional rotary spatial ALD devices which can only coat a single side of the substrate and need a step of breaking the vacuum typically used for applying the precursors and/or reactants, flipping the substrate and running the ALD process for the lower side of the substrate again. At the same time, a more uniform coating can be achieved, as uncertainties in the processing parameters are reduced compared to a several-run spatial ALD coating procedure.

The uniformity and conformality of the coating are further improved, as the path length is reduced that a given precursor or co-reactant molecule must pass after being dosed from the respective gas processing assembly until finding a suitable spot for connecting to the surface of the substrate. This also allows to uniformly and conformally coat taller substrates on all surfaces in one process run than is possible with a single-side ALD method.

Furthermore, the intrinsic stress of the coating achieved with the ALD procedure is reduced, as the stress during layer growth of the coating can be better compensated when several sides of the substrate are coated at the same time, especially when being coated all-around on all surfaces of the substrate.

Also, the resources used for operating the deposition device are more efficiently used when coating more than one surface of the substrate in one run, thereby increasing the sustainability of the deposition device.

The deposition device may comprise at least one pair of plasma electrodes, wherein a first plasma electrode of the pair of plasma electrodes is arranged above the turntable and a second plasma electrode of the pair of plasma electrodes is arranged below the turntable in overlap with the first plasma electrode. The at least one pair of plasma electrodes enables the device to be used in a plasma assisted ALD process in which a layer previously applied on the substrate, e.g. in the gas reaction station, is further reacted in a plasma generated in front of each of the plasma electrodes.

The at least one pair of plasma electrodes can be arranged at the same radial position as the receptacle with respect to a rotation axis of the turntable, thereby forming a plasma reaction station. As the plasma electrodes of the at least one pair of plasma electrodes are arranged at the same radial position, both the upper and lower sides of the substrate, which is encompassed in the receptacle, can be easily and completely covered by the plasma, thereby further ensuring a uniform and complete reaction of any chemical species being present on the surface of the substrate. Such a configuration is especially beneficial if tall substrates are to be coated, as plasma coverage of the surface decreases the taller the substrate is, i.e. the further apart the outer parts of the surface of the substrate are from a given plasma electrode. The at least one pair of plasma electrodes can increase the range for which a sufficient plasma coverage is achieved, e.g. doubles the available range compared to conventional single side plasma-assisted ALD devices utilizing the same type of plasma electrode.

The distance between the plasma electrodes of the pair of electrodes determines the maximum size of the substrate which can be placed between the electrodes and may be up to 200 mm, e.g. up to 70 mm, up to 60 mm, up to 50 mm or up to 40 mm. That is, the substrate may have height of up to 200 mm, e.g. up to 140 mm, up to 120 mm, up to 100 mm or up to 80 mm.

In these cases, the plasma generated in front of each of the plasma electrodes of the pair of plasma electrodes preferably extends at least over half the height of the respective substrate.

In case the lower and upper surfaces of the substrate are not equally spaced apart from one of the plasma electrodes of the pair of plasma electrodes, e.g. in case of a dome-shaped substrate, the surface of the substrate being further away from the associated plasma electrode of the pair of plasma electrodes especially has a maximal distance to the associated plasma electrode of the pair of plasma electrodes which is at most the maximum range of the plasma generated in front of the associated plasma electrode of the pair of plasma electrodes.

For further increasing the deposition rate of the coating and thereby further improving the efficiency of the spatial ALD device, the deposition device can comprise a plurality of pairs of gas processing assemblies and/or a plurality of pairs of plasma electrodes. That is, the device may have a plurality of gas reaction stations and/or plasma reaction stations.

It is also possible that one of the gas reaction stations of the plurality of gas reaction stations is connected to an external plasma supply which is adapted to apply a stream of plasma, i.e. a stream of excited gas, to the gas reaction station and therefore to a substrate in the respective gas reaction station. This allows to realize a plasma-assisted ALD process without the need to use a plasma reaction station including a pair of plasma electrodes or at least reduce the number of such plasma reaction stations. The stream of plasma might be obtained from a plasma generated from a DC or RF source. E.g., the stream of plasma might be obtained from a capacitively coupled plasma (CCP), an inductively coupled plasma (ICP), a microwave plasma, or an arc discharge plasma, e.g. a plasma generated in a hollow cathode.

By using a plurality of gas reaction stations, the variability in applying the precursor and/or the co-reactant onto the substrate further increases. E.g., in a first of the plurality of gas reaction stations, a precursor might be applied only onto the upper side of the substrate, while in a second of the plurality of gas reaction stations a precursor might be applied only onto the lower side of the substrate and/or onto both the upper and the lower side of the substrate or vice versa. This set-up also allows to use different precursors for forming a coating on the upper and the lower side of the substrate.

The sequence of gas reaction stations and plasma reaction stations along the rotation direction of the turntable can be adapted to the intended type of reactions necessary to produce the desired type of coating.

E.g., the pairs of gas processing assemblies can be arranged alternating with the pairs of plasma electrodes. That is, the device might have gas reaction stations and plasma reaction stations that are arranged in an alternating pattern along the rotation direction of the turntable, e.g. with a plasma reaction station following directly after each gas reaction station and a gas reaction station following directly after each plasma reaction station. Such an arrangement allows to run more than one ALD cycle per full rotation of the turntable, thereby further improving the throughput of the deposition device.

It is also possible that at least two plasma reaction stations are arranged after each other along the rotation direction of the turntable. Such an arrangement is especially beneficial if chemical species are to be obtained in the coating which require longer plasma exposure times, e.g. nitrides. In this way, it can be avoided that the overall deposition rate and the throughput of the device is compromised by slowing down the turntable to achieve a sufficient long plasma exposure time in a single plasma reaction station.

The plasma exposure time might also be adjusted based on the design of the plasma electrodes of the at least one pair of plasma electrodes. E.g., by increasing the size of the plasma electrodes along the rotational axis of the turntable, the plasma exposure time within a single plasma reaction station can be increased.

The device can further comprise a mask which is arranged in front of the plasma electrode(s) between the plasma electrode(s) and the substrate for tuning the plasma exposure time of the substrate. The mask can be used to adjust the exposure time of the substrate to the plasma and/or the plasma geometry such that an optimized coverage for a given substrate can be obtained.

The mask can be an in-situ tunable mask such that plasma exposure time and/or the plasma geometry can be adjusted to the respective substrate even during operation of the deposition device.

It is also possible that more than one pair of plasma electrodes is used within one plasma reaction station to increase the plasma coverage within a single plasma reaction station.

In another variant, the first plasma electrode and the second plasma electrode of the at least one pair of plasma electrodes have a non-planar shape. The non-planar shape can be adapted to the substrate geometry such that the distance between the surface of the substrate and the respective plasma electrode is minimized. E.g., the first plasma electrode and the second plasma electrode may have a rounded shape which is especially beneficial if the substrate has a corresponding rounded shape, e.g. an essentially spherical or elliptical (convex and/or concave) shape.

Of course, any non-planar shape of the plasma electrode has to be chosen in such a way that the rotation of the turntable is not hindered, i.e. collisions between the substrate and the respective plasma electrode is avoided.

E.g., the non-planar shape can be a tunnel shape with a curvature in the radial direction.

At least one pair of gas processing assemblies may have a different spray pattern than another pair of gas processing assemblies of the plurality of gas processing assemblies. That is, if more than one gas reaction station is present in the deposition device, the gas processing assemblies might be different between at least two of the gas reaction stations, e.g. having shower heads being different from the others. This allows further optimization of how the gas is applied onto the substrate based on the intended chemical reactions and/or shape of the substrate to achieve good uniformity for different target materials in a coating, and thereby of the ALD process.

The deposition device can comprise a control unit which is configured to control a supply of gas, particularly a gas comprising a precursor and/or a co-reactant, through the gas processing assemblies, wherein the control unit is configured to control a flow of gas based on the gas used. E.g., the control unit may be configured to control the flow of gas by opening or closing valves that are assigned to a specific pair of gas processing assemblies.

The control unit used for controlling the supply of gas can be configured to control further components and/or process conditions during operation of the deposition device.

E.g., the control unit can further be configured to control a power supply of the plasma electrodes used for generating a plasma. If multiple plasma reaction stations are used within the deposition device, the control unit can be configured to control the power supply of multiple pairs of plasma electrodes at the same time and independent of each other. This is especially useful if challenging materials like nitrides are to be deposited on the substrate.

Also, the control unit can be configured to control the in-situ tunable mask in front of at least one plasma electrode for adjusting the plasma exposure time and/or the plasma geometry.

The type of precursors and co-reactant is not further limited as long as the desired type of coating can be obtained from the respective precursor and/or co-reactant by the ALD process.

The coating to be formed on the substrate is especially a coating rendering the coated substrate suitable for optical applications. E.g., the coating can be an oxide, a nitride, a fluoride, a sulfide and/or a metal.

The precursor may be a metal-containing precursor and may be a metal halide, a metal β-diketonate complex, a metal alkoxide, a metal alkyl compound, a metallocene, a metal amido complex, a metal carbonyl and/or a metal nitrate.

The metal of the metal-containing precursor might be selected from the group of Hafnium, Ruthenium, Titanium and combinations thereof.

Exemplary substances being suitable precursor compounds are hafnium tetrachloride (HfCl₄), Tris(2,2,6,6-tetramethyl-3,5-heptanedionato)ruthenium (Ru(thd)₃), Titanium(IV)-isopropoxide (TTIP), trimethylaluminium (TMA), and Tris(dimethylamido)cyclopentadienylhafnium (HfCp(NMe₂)₃).

The co-reactant is selected dependent on the type of coating to be obtained on the substrate. If an oxide is to be formed as coating, exemplary co-reactants are water, ozone, hydrogen peroxide, an oxygen plasma and an carbon dioxide plasma. If a nitride is to be formed as coating, exemplary co-reactants are ammonia, a nitrogen plasma and a nitrogen:hydrogen plasma. If a fluoride is to be formed as coating, exemplary co-reactants are molecular fluorine, hydrogen fluoride, a fluorocarbon plasma, a hydrofluorocarbon plasma and a sulfur hexafluoride plasma. If a sulfide is to be formed as coating, exemplary co-reactants are hydrogen sulfide and a hydrogen sulfide plasma. If a metal is to be formed as coating, exemplary co-reactants are a hydrogen plasma, a nitrogen:hydrogen plasma and an ammonia plasma.

To further increase the variability of the gas processing assemblies of the device, the control unit can be configured to control the flow of gas individually for the gas processing assemblies, in particular wherein the control unit is configured to control the flow of gas such that different gases are provided to the first gas processing assembly and the second gas processing assembly.

For removing excess gas, which cannot contribute to forming the desired layer on the substrate, from the gas processing assembly, the gas processing assemblies each may comprise at least one gas outlet port for exhausting a gas from the gas reaction station.

The deposition device can comprise a bottom plate and a top plate, wherein the first gas processing assembly is integrated in the top plate and the second gas processing assembly is integrated in the bottom plate. In this way, the device can be made especially compact. Furthermore, such a design allows to form the device from a set of multiple bottom plates and/or multiple top plate which differ from each other, e.g. in their thickness and/or in the design of the integrated gas processing assemblies, such that the respective gas processing assemblies are optimal for a given substrate which is to be coated and/or a given turntable mounted between the bottom plate and the top plate.

E.g., a turntable chosen from different turntables with different thicknesses can be installed in the device to accommodate substrates with different heights. This also allows to adjust the distance of the top plate and the bottom plate holding the showerheads used for applying the gas onto the substrate, as well as holding plasma electrodes in case of plasma-assisted ALD.

The top plate and the bottom plate are non-destructively connected to each other such that at least one of the top plate and the bottom plate can be removed to access the turntable.

The connection of the top plate and the bottom plate can be gas-tight to reduce the amount of gas being expelled at the contact surfaces between the top plate and the bottom plate.

The bottom plate and/or the top plate can be connected to a housing forming a chamber of the deposition device in which the turntable, the top plate and/or the bottom plate are arranged. The chamber facilitates to ensure a desired pressure within the chamber during operation of the deposition device, e.g. a vacuum. Furthermore, the chamber provides a thermal separation between the outside of the housing and the top plate, bottom plate and turntable placed within the chamber, which improves thermal safety and controllability of the overall deposition device.

The housing may comprise a housing door which can be opened to access the further components of the deposition device arranged in the chamber, e.g. the top plate, the bottom plate and/or the gas processing assemblies.

In one variant, the top plate is connected to the housing door such that the top plate is lifted away from the turntable when the housing door is opened. This allows for an easier and faster access to the turntable.

The top plate and/or the bottom plate might be connected to the housing such that the position within the housing can be adjusted. E.g., the top plate and/or the bottom plate can be movable by a drive such that the distance between the top plate and/or the bottom plate can be adjusted to encompass different turntables of differing heights.

It is also possible that the deposition device comprises a heating. The heating allows to control the temperature of the substrate and thereby the reaction taking place during formation of the coating. In this way, it is possible to avoid local temperature sinks along the substrate, thereby further improving the uniformity of the obtained coating.

The temperature the substrate should be heated to is dependent on the type of coating to be formed and the type of ALD process used in the deposition device. Generally, a thermal ALD procedure will require higher temperatures of the substrate than a plasma-assisted ALD procedure. E.g., in case a plasma-assisted ALD procedure is used, the substrate can be heated to a temperature of up to 300 °C, while in case a thermal ALD procedure is used, the substrate can be heated to a temperature of up to 500 °C.

Of course, the temperature used should be chosen such that the used precursor is not decomposed solely to the high temperature without being reacted with the substrate.

The heating can include heating elements being integrated in the top plate, the bottom plate and/or the turntable. E.g., the heating element can be a heating fluid line which is configured to be flushed with a heating fluid. The heating element can also be an electrical heating element.

Especially, the heating element can be integrated in the top plate and/or the bottom plate such that the gas provided by the gas processing assemblies can be heated when flowing through the respective top plate or bottom plate before being dosed on the substrate.

The heating further ensures that any precursor and/or co-reactant used for preparing the desired coating does not condensate within the deposition device. It is also possible that the heating comprises an input heating element, e.g. a heat exchanger, which is in contact with one or more gas input ports or gas input lines adapted to dose the gas comprising the precursor or the co-reactant to the substrate to avoid condensation of the gas before being applied onto the substrate.

The same control unit used for controlling the supply of gas through the gas processing assemblies can be configured to control the operation of the heating.

The deposition device can comprise a housing forming a chamber in which the top plate, the bottom plate and the turntable is arranged, wherein the chamber is heated to the desired temperature to further ensure that no condensation of the precursor and/or the co-reactant occurs within the chamber.

To ensure gas separation between the different processing stations of the deposition device, the deposition device may comprise a center gas showerhead being arranged in a center region of the turntable which is configured to inject a process gas between the top plate and the bottom plate, thereby creating a gas curtain between the processing stations of the deposition device. The gas curtain prevents that reactive species diffuse from their associated processing station to other processing stations and thereby prevents unwanted intermixing between different reactive species even during rotation of the turntable.

The deposition device might comprise gas curtain evacuation ports arranged in or at an radially outwards end region of the top plate and/or the bottom plate. Dependent on the number and position of the evacuation ports, the shape and size of the gas curtain formed between the center gas showerhead and the gas curtain evacuation ports can be determined.

E.g., the gas curtain can be of a linear shape, a Y-shape or a X-shape in a top view.

It is also possible that the gas curtain is created by a single gas shower arranged between neighboring processing stations of the deposition device.

The type of process gas injected through the center gas showerhead can be adapted to the type of reaction stations being present in the deposition device and the type of ALD process run with the deposition device.

In case of a thermal ALD process, in which a first gas comprising a precursor and a second gas comprising a co-reagent are injected at separate gas reaction stations, the gas curtain formed should avoid intermixing of the precursor and the co-reagent, but without interfering with the individual reactions taking place at the respective processing stations. Thus, the processing gas especially is an inert gas, e.g. nitrogen.

In case a plasma-assisted ALD process is used, the gas separation realized by the gas curtain is of less importance, as the co-reactant used for forming the plasma can be more easily chosen such to be not reactive with the used precursor in the gas reaction station. This allows the process gas to comprise, alternatively to or in addition to an inert gas, the co-reactant used for generating the desired plasma species, e.g. oxygen, carbon dioxide, hydrogen and/or molecular fluorine.

The object of the invention is also solved by a system with a deposition device as described before and at least two turntables, wherein each of the least two turntables differ from each other.

The features and advantages explained above for the deposition device apply for the system, too, and vice versa and it is explicitly referred to the explanations given above.

The at least two turntables can differ from each other in their thickness. By having turntables of differing thicknesses available in the system, the turntable being best suitable for the size of a given substrate which is to be coated can be chosen from the at least two turntables, thereby improving the flexibility of the overall system. Specifically, turntables of differing thickness can accommodate substrates with different heights.

Further, the distance between the electrodes and the first gas processing assembly and/or the second gas processing assembly, especially the distance between the electrodes and the showerheads, can be varied via the turntable thickness, if the distance between the top plate and the bottom plate of the deposition device is kept constant.

The at least two turntables can be realized as a multi-part turntable formed from a base turntable having a first thickness and an extension piece being connectable to the base turntable to obtain a turntable of differing thickness.

The system can also comprise a plurality of matched sets each comprising a top plate and a bottom plate, wherein the matched sets differ from each other. E.g., the plurality of matched sets might comprise top plates and bottom plates of differing size and/or having different types of gas processing assemblies and/or plasma electrodes integrated in the respective top plate and bottom plate.

Thus, the system can be configured as modular system which allows to adjust the components of the deposition device in an optimal manner to a given substrate such to ensure optimal coating growth.

The object of the invention is further solved by a method for coating a substrate in a deposition device, particularly the deposition device as described before, wherein the deposition device comprises a turntable and at least a first pair of gas processing assemblies, wherein a first gas processing assembly of the first pair of gas processing assemblies is arranged above the turntable and a second gas processing assembly of the first pair of gas processing assembly of the first pair of gas processing assemblies is arranged below the turntable in overlap with the first gas processing assembly, wherein the gas processing assemblies together form a gas processing station, and wherein the deposition device comprises a second pair of gas processing assemblies and/or a pair of plasma electrodes in addition to the first pair of gas processing assemblies which is spaced with a distance to the second pair of gas processing assemblies and/or the pair of plasma electrodes in a circumferential direction. The method comprises the following steps:
a) A substrate is placed in a receptacle of the turntable;
b) the turntable is rotated such that the substrate is turned through the gas reaction station associated with the first pair of gas processing assemblies;
c) at least a first gas is injected into the reaction chamber from both gas processing assemblies of the first pair of gas processing assemblies;
d) the turntable is further rotated such that the substrate is turned through between the gas processing assemblies of the second pair of gas processing assemblies or between the plasma electrodes of the pair of plasma electrodes; and
e) at least a second gas is injected from the second pair of gas processing assemblies or a plasma is ignited by the pair of plasma electrodes.

The features and advantages explained above for the deposition device apply to the method for coating a substrate, too, and vice versa and it is explicitly referred to the explanations given above.

In the method according to the invention, after being placed in the receptacle, the substrate is rotated by the turntable through the first pair of gas processing assemblies and afterwards through the gas processing assemblies of the second pair of gas processing assemblies or between the plasma electrodes of the pair of plasma electrodes, thereby ensuring that the individual process steps necessary for forming the desired coating on the substrate is realized.

To increase the throughput of the method, the substrate may be dynamically coated. That is, the turntable can be rotated with a pre-selected rotational speed such that the substrate is constantly moved between the different stations present in the deposition device. Thus, the substrate is not kept in a fixed position during application of the first gas and the second gas or the plasma, but moved through the respective station while the respective first gas and second gas or plasma is provided.

The pre-selected rotational speed might be in the range of from 1 to 500 rpm.

Of course, steps b) to e) of the method as described above therefore do not provide a fixed temporal sequence of steps. That is, after the substrate is placed in the receptacle of the turntable, the first gas can be injected into the reaction chamber from both gas processing assemblies of the first pair of gas processing assemblies and/or the second gas can be injected from the second pair of gas processing assemblies or a plasma can be ignited by the pair of plasma electrodes before the turntable starts to rotate and/or before the substrate enters the respective reaction station for the first time.

The method according to the invention allows to efficiently coat the substrate from both above and below the substrate in a single run. The s-ALD procedure can be run as thermal ALD process, when the second pair of gas processing assemblies is used, or as plasma-assisted ALD process, if the pair of plasma electrodes is used.

To ensure gas separation between the different processing stations of the deposition device, before the first gas is injected into the reaction chamber and/or the second gas is injected or a plasma is ignited by the pair of plasma electrodes, a process gas can be injected from a center gas showerhead being placed in the center of the turntable, thereby creating a gas curtain from the process gas. The gas curtain prevents that reactive species diffuse from their associated reaction station to other reaction stations and thereby prevents unwanted intermixing between different reactive species even during rotation of the turntable.

Further features and advantages will become more apparent from the following description of exemplary embodiments, which are not to be understood as limiting, and the Figures. In the Figures:
- Fig. 1 shows a schematic depiction of a spatial atomic layer deposition device according to the invention;
- Fig. 2 shows selected parts of the deposition device of Fig. 1 in more detail;
- Fig. 3 shows an upper view on selected parts of the deposition device of Fig. 1;
- Fig. 4 shows an upper view analogous to Fig. 3 of a variant of the deposition device of Fig. 1;
- Fig. 5 shows selected parts of a further variant of the deposition device of Fig. 1 in more detail; and
- Fig. 6 shows a block diagram of a method according to the invention for coating a substrate in a deposition device of Fig. 1.

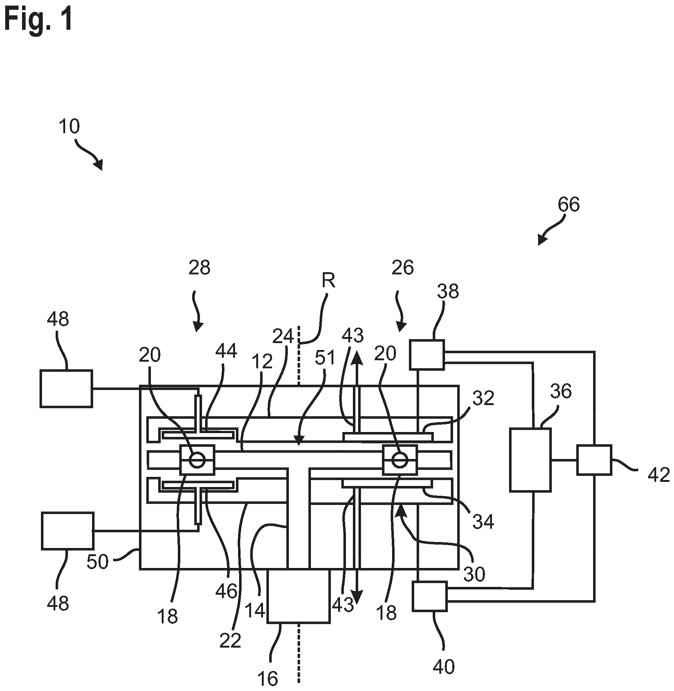

Fig. 1 shows a schematic depiction of a spatial atomic layer deposition, s-ALD, device 10 according to the invention, which in the following is also referred to as deposition device 10.

The deposition device 10 comprises a turntable 12 which is rotatable around a rotation axis R placed in the center of the turntable 12. The turntable 12 has a generally point-symmetric shape around its center, e.g. has a circular outer contour or an outer contour forming a regular polygon.

In the center of the turntable 12, the turntable 12 is connected to a support shaft 14 which is collinear with the rotation axis R and in turn is connected to a drive 16, e.g. an electric motor unit. The drive 16 is configured to rotate the support shaft 14, thereby also rotating the turntable 12.

In the schematic depiction of Fig. 1, turntable 12 and support shaft 14 are shown as being formed integrally. Of course, turntable 12 and support shaft 14 can also be made of individual parts being connected to each other.

The turntable 12 comprises several receptacles 18 which extend through the turntable 12, i.e. from an upper side of the turntable 12 to a lower side of the turntable 12.

The receptacles 18 are arranged at a same radial distance from the center of the turntable 12 such that upon rotation of the turntable 12, the receptacles 18 are moved along a circular path with a constant radial distance from the center of the turntable 12.

Within the receptacles 18, substrates 20 are placed which are to be coated within the deposition device 10. The substrates 20 encompassed by the receptacles 18 are accessible from both above and below the turntable 20.

The type and shape of substrate 20 is not further limited, as long as it can withstand the process conditions of typical ALD processes.

The turntable 12 can also be of a (not shown) multi-part construction. E.g., the turntable 12 can be constructed from a disc-shaped central part, spokes connected to the central part and extending parallel to the rotation axis R, and substrate holders being arranged between and connected to the spokes and comprising the receptacles for the substrates.

The deposition device 10 further comprises a bottom plate 22 and a top plate 24, with the bottom plate 22 being arranged below the turntable 12 and the top plate 24 being arranged above the turntable 12 such that the turntable 12 is encompassed by the bottom plate 22 and the top plate 24.

The bottom plate 22 and the top plate 24 are connected to each other and do not rotate upon rotation of the turntable 12.

Integrated into the bottom plate 22 and the top plate 24 are a gas reaction station 26 and a plasma reaction station 28.

The gas reaction station 26 is formed by a gas processing assembly 30 which is arranged at the same radial position as one of the receptacles 18.

The gas processing assembly 30 includes a first gas processing assembly 32 being arranged above the turntable 12 and being integrated in the top plate 24, and a second gas processing assembly 34 being arranged below the turntable 12 and being integrated in the bottom plate 22.

The first gas processing assembly 32 is fluidically connected to a gas supplying unit 36 by means of a first valve 38, and the second gas processing assembly 34 is fluidically connected to the gas supplying unit 36 by means of a second valve 40.

The gas supplying unit 36 forms a reservoir for a gas comprising a precursor and/or a co-reactant, which is injectable from the gas supplying unit 36 through the first valve 38 and the first gas processing assembly 32 to the upper side of the substrate 20 and from the gas supplying unit 36 through the second valve 40 and the second gas processing assembly 34 to the lower side of the substrate 20.

The flow of gas is controlled by a control unit 42 which is interfaced with the gas supplying unit 36, the first valve 38 and the second valve 40. That is, the control unit 42 is configured to control the first valve 38 and the second valve 40, i.e. to open or close the first valve 38 and the second valve 40.

The control unit 42 is further configured to control the flow of gas to the first gas processing assembly 32 and to the second gas processing assembly 34 independently from each other. This also allows to provide different gases to the first gas processing assembly 32 and the second gas processing assembly 34 in case the gas supplying unit 36 is configured to provide different gases, e.g. from different precursor and co-reactor tanks included in the gas supplying unit 36. This configuration facilitates coating upper and lower surfaces of the substrates 20 with different materials in the same process run.

Each of the first gas processing assembly 32 and the second gas processing assembly 34 further comprises at least one gas outlet port 43 for exhausting excess gas from the gas reaction station 26. Said outlet ports 43 are connected to a pump system which is not shown in detail in Fig. 1, but only indicated by arrows.

The plasma reaction station 28 is formed by a pair of plasma electrodes which are arranged at the same radial position as the other one of the receptacles 18, i.e. the receptacle 18 which is not located at the gas reaction station 26 in the state of the deposition device 10 shown in Fig. 1.

The plasma reaction station 28 includes a first plasma electrode 44 being arranged above the turntable 12 and being integrated in the top plate 24, and a second plasma electrode 46 being arranged below the turntable 12 and being integrated in the bottom plate 22.

The first plasma electrode 44 and the second plasma electrode 46 are each connected to a power supply 48, which is associated to the respective plasma electrode 44 and 46 and provides the power necessary to generate a plasma within the plasma reaction station 28 in front of the respective plasma electrode 44 and 46.

The turntable 12, the gas reaction station 26 and the plasma reaction station 28 are placed within a housing 50 forming a chamber in which the turntable 12, the top plate 24 and the bottom plate 22 are arranged in. The housing 50 is operated such that within the housing 50 a vacuum, or a low pressure or an atmospheric pressure with inert environment is maintained which is suitable for ALD, especially a vacuum or a low pressure of less than 300 Pa, like a pressure in the range of from 20 to 270 Pa.

The term "vacuum" here denotes a pressure of less than 100 Pa.

Of course, depending on if one wants to conduct ALD under vacuum/low pressure or inert atmospheric pressure conditions, further changes in the arrangement of the components of the deposition device 10 might be necessary, e.g., to reduce the distance between the turntable 12 and the top plate 24 and the bottom plate 22 to the micrometer scale in case of thermal ALD.

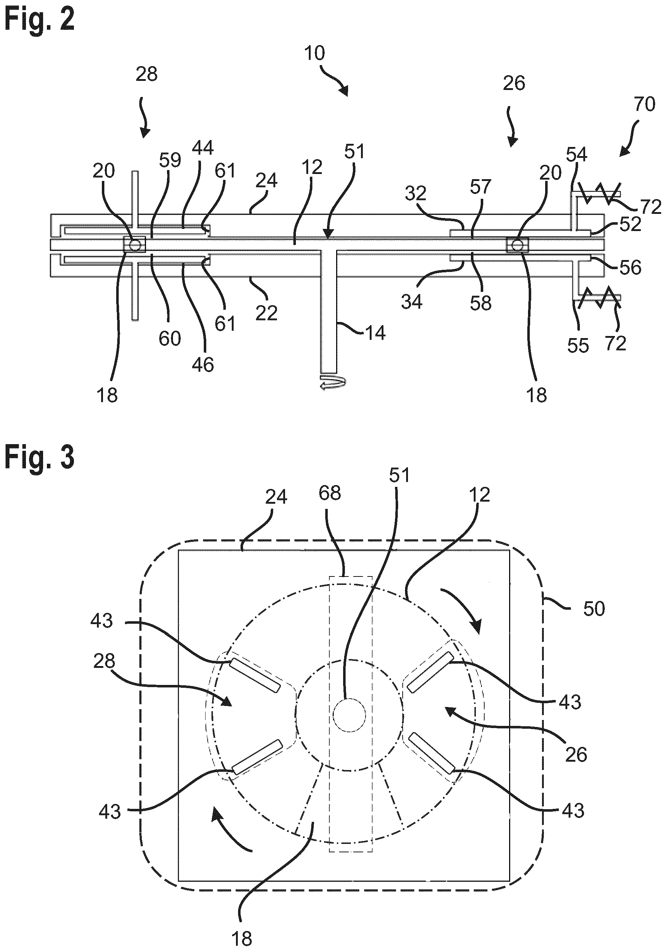

Fig. 2 shows selected parts of the deposition device 10 in more detail.

The first gas processing assembly 32 comprises a first showerhead 52 which is connected to a first gas inlet port 54 fluidically connecting the first valve 38 with the showerhead 52. Analogously, the second gas processing assembly 34 comprises a second showerhead 56 which is connected to a second gas inlet port 55 fluidically connecting the second valve 40 with the second showerhead 56.

The specific design of the showerheads 52 and 56 can be chosen based on the type of substrate 20 to be coated and typically comprise one or more gas nozzles for applying the gas dosed to the respective showerhead 52 or 54 onto the substrate 20.

Between the first showerhead 52 and the upper surface of the turntable 12, a first gap 57 is formed, and between the second showerhead 56 and the lower surface of the turntable 12, a second gap 58 is formed.

The size of the gaps 57 and 58 along an axis parallel to the rotation axis R is as small as possible to achieve the intended distribution of gases across the substrate surface, but big enough that any kind of substrate 20 which is intended to be coated with the given combination of turntable 12, bottom plate 22 and top plate 24 can be fitted in the receptacle 18 without touching the bottom plate 22 and the top plate 24 to ensure that the rotation of the turntable 12 is not impacted.

As explained before, the plasma reaction station 28 comprises a first plasma electrode 44 integrated in the top plate 24 and a second plasma electrode 46 in the bottom plate 22.

Each of the plasma electrodes 44 and 46 are accommodated in a recess 61 in the associated top plate 24 and bottom plate 22, respectively.

Similar to the gas reaction station 26, between the first plasma electrode 44 and the upper surface of the turntable 12, a third gap 59 is formed, and between the second plasma electrode 46 and the lower surface of the turntable 12, a fourth gap 60 is formed.

Again, the size of the gaps 59 and 60 along an axis parallel to the rotation axis R is as small as possible to ensure that the plasma generated by the respective plasma electrode 44 and 46 is in as close proximity to the substrate 20 as possible in order to receive sufficient flux of the reactive plasma species at the substrate surface intended to be coated.

The small gaps 57 to 60 ensure the close proximity of the showerheads 52 and 56 and of the plasma electrodes 44 and 46, respectively, to the surfaces of the substrate 20 such to ensure the best coverage of the surface with the gas and plasma, respectively.

Furthermore, the distance between the turntable 12 and the top plate 24 as well as the distance between the turntable 12 and the bottom plate 22 is as small as possible in a central region of the turntable 12, too, i.e. in a region in which neither the gas reaction station 26 nor the plasma reaction station 28 is present. Such an arrangement further decreases the likelihood of gas exchange taking place between the gas reaction station 26 and the plasma reaction station 28, thereby improving the controllability of the deposition process and further improving the uniformity of the obtained coatings. That is, due to the small size of the gap, any gas dosed into the gas reaction station 26 or the plasma reaction station 28 is essentially only present at said station, i.e. unwanted diffusion processes are effectively suppressed, thereby improving the control of the ALD process.

The distance between the turntable 12 and the top plate 24 and the distance between the turntable 12 and the bottom plate 22 might be less than 10 mm, e.g. in the range of from 1 to 5 mm or from 3 to 5 mm.

To further improve gas separation, a process gas can be applied in a center region of the turntable 12 by a center gas showerhead 51 whose position is only indicated by an arrow in Figs. 1 and 2 due to the plane of the schematic cut shown in these Figures.

The process gas can be supplied from the same gas supplying unit 36 as the precursor and/or the co-reactant or from an additional (not shown) process gas supplying unit. The control unit 42 can be configured to control the center gas showerhead 51, or an additional control unit can be used to control the operation of the center gas showerhead 51.

Fig. 3 shows an upper view of selected parts of the deposition device 10 from which the effect of the process gas applied by the center gas showerhead 51 becomes more evident.

The process gas applied by the center gas showerhead 51 distributes in an area defined by the position of the center gas showerhead 51 and further gas curtain evacuation ports not explicitly shown in the schematic depiction of Fig. 3.

However, Fig. 3 depicts the general shape of a gas curtain 68 formed by the process gas which, in the upper view provided in Fig. 3, is of linear shape and forms a barrier between the gas reaction station 26 and the plasma reaction station 28.

It is also possible that the center gas showerhead 51 comprises a plurality of individual nozzles which are arranged along the length of the desired gas curtain, e.g. in a linear arrangement to realize the linear shape indicated in Fig. 3.

The gas curtain 68 makes it possible to use larger distances between the turntable 12 and the top plate 24 and the bottom plate 22 than set-ups without a gas curtain, as intermixing of gases present at the different reaction stations is efficiently suppressed.

The type of process gas can be chosen depending of the reaction stations used in the deposition device 10. E.g., the process gas can comprise or be an inert gas.

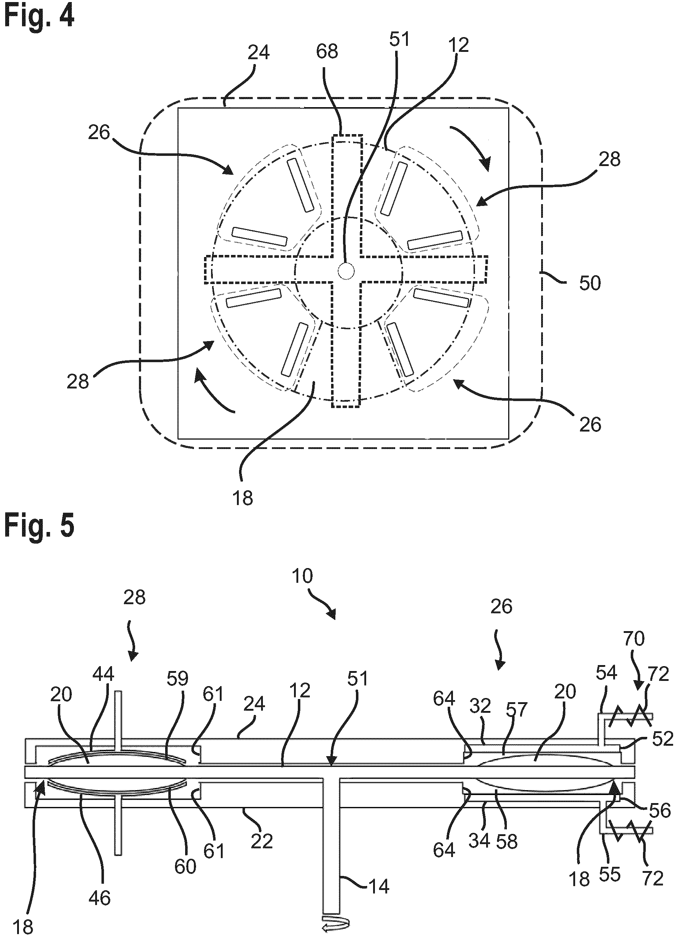

Fig. 4 shows a top view analogous to Fig. 3 of a further variant of the deposition device 10.

In the further variant, two gas reaction stations 26 and two plasma reaction stations 28 are present, wherein the gas reactions stations 26 and the plasma reaction stations 28 are arranged in an alternating sequence along the rotation direction of the turntable 12 (indicated by arrows in Figs. 3 and 4). Such an arrangement further increases the throughput of the deposition device 10, as with one full rotation of the turntable 12 several ALD cycles can be run.

Furthermore, Fig. 4 highlights that in such an arrangement the shape of the gas curtain 68 is adapted to the number and arrangement of gas reaction stations 26 and plasma reaction stations 28 by having an overall X-shape in the top view of Fig. 4.

Of course, the gas curtain 68 can have other shapes than indicated in Figs. 3 and 4, merely depending on the choice of position of the center gas showerhead 51, the number of individual nozzle of the center gas showerhead 51 and the associated gas curtain evacuation ports.

Coming back to Fig. 2, the deposition device 10 further comprises a heating 70.

In the shown embodiment, the heating 70 comprises heating elements 72, e.g. heat exchangers, which are associated to the first gas inlet port 54 and the second gas inlet port 56.

The heating 70 is configured such to ensure that the gas provided in the gas reaction station 26, especially the precursor, cannot condensate on its flow path from the gas supplying unit 36 to the respective valve 38 and 40 to the substrate 20. Further, the heating 70 can provide for the desired temperature range during chemical reactions taking place when the precursor is reacted with the surface of the substrate 20.

It is also possible that the heating 70 comprises additional heating elements being integrated in the top plate 24, the bottom plate 22 and/or the turntable 12 to realize the desired temperature and avoid temperature sinks along the substrate 20.

Also, the exhaust port 43 can be heated by the heating 70 to avoid condensation of any gas components until reaching the pump system located outside of the housing 50.

In the following, the mode of action of the deposition device 10 is further explained together with a method for coating a substrate 20 according to the invention.

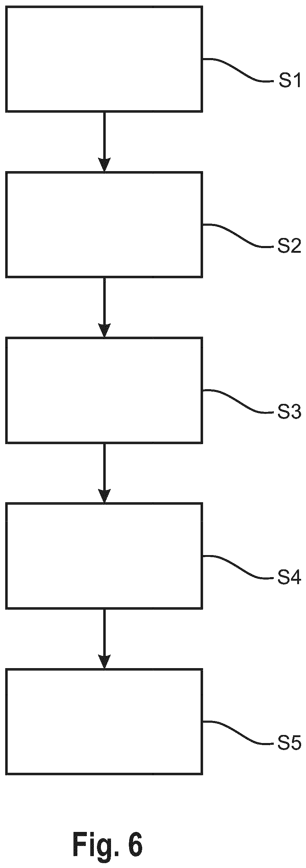

In a first step, the substrate 20 is placed in one of the receptacles 18 of the turntable 12 (see step S1 in Fig. 6). As the receptacle 18 extends through the turntable 12, both the upper surface of the substrate 20 and the lower surface of the substrate 20 is accessible by the reactive gaseous species after placing the substrate 20 in the receptacle 18.

Then, the process gas will start to get injected by the center gas showerhead 51 to create the gas curtain 68.

At least a first gas is injected into the gas reaction station 26 from both the first gas processing assembly 32 and the second gas processing assembly 34, respectively, through the gas inlet ports 54 and 55 (see step S2 in Fig. 6), especially in a continuous manner.

The gas flow is controlled based on at least one control signal sent by the control unit 42 and received by the gas supplying unit 36, the first valve 38 and the second valve 40.

The first gas includes at least one precursor which is used to form an atomic layer of precursor and/or of one or more reaction products formed from the precursor on the substrate 20.

The type of precursor is not limited as long as it is suitable for being subjected to the type of reactions necessary to build the type of coating intended to be applied on the substrate 20. E.g., the precursor can be a metal containing compound capable of being bound to the surface of the substrate 20. In general, the precursor used will be a specifically synthesized ALD precursor having self-terminating reaction properties, which gives ALD the advantage of producing uniform and conformal coatings.

It is also possible that the amount and/or type of gas which is supplied by the first gas processing assembly 32 and the second gas processing assembly 34 to the substrate differs, based on the control signals sent by the control unit 42 to the gas supplying unit 36, the first valve 38 and the second valve 40.

Then, a plasma is ignited in front of each of plasma electrodes 44 and 46 used to convert the adsorbed chemical species forming an atomic layer on the substrate surface to the desired coating material (see step S3 in Fig. 6). E.g., the monolayer is converted to a metal oxide monolayer in the plasma.

The turntable 12 will then start to rotate such that the receptacle 18 holding the substrate 20 starts to rotate, e.g. with a pre-selected rotational speed in the range of from 1 to 500 rpm.

Due to the rotation of the turntable 12, the substrate 20 is turned through the gas reaction station 26 (see step S4 in Fig. 6). That is, the substrate 20 will pass between the first gas processing assembly 32 and the second gas processing assembly 34.

As the substrate 20 is accessible from both its upper side and its lower side, an atomic layer can be formed at least on the upper surface of the substrate 20 and on the lower surface of the substrate 20, especially on all surfaces of the substrate 20, such that after a single gas application step several surfaces of the substrate 20 are covered with the atomic layer.

Any reaction products formed as by-product of the reaction forming the atomic layer and/or unreacted ligands of the precursor which do not participate in the reaction forming the atomic layer, can be sucked off via the gas outlet ports 43.

After leaving the gas reaction station 26, due to the ongoing rotation of the turntable 12, the substrate is further rotated such that the receptacle 18 holding the substrate 20 is turned through the plasma electrodes 44 and 46 of the plasma reaction station 28 (see step S5 in Fig. 6).

Again, as the substrate 20 is accessible from both its upper and lower sides, the atomic layer on several surfaces of the substrate 20 are converted to the desired coating in a single step, preferably on all surfaces of the substrate 20.

Due to the ongoing rotation of the turntable 12, the substrate 20 will be turned through the gas reaction station 26 and the plasma reaction station 28 again. Depending on the desired thickness of the coating on the substrate 20, steps S5 and S6 can be repeated until the targeted coating thickness is deposited on the substrate 20.

As indicated in Fig. 2, the turntable 12 can comprise several receptacles 18, wherein, in step S1, a substrate 20 is placed in each of the receptacles 18. This allows to further increase the output of the deposition device 10, as both substrates 20 can be treated in parallel within different processing stations of the deposition device 10. It is also possible that several receptacles 18 are arranged such that several substrates 20 are moved together through the same reaction station of the deposition device 10 in parallel.

In the sequence discussed above, a plasma-assisted ALD process is realized by using a first gas processing assembly 30 as gas reaction station 26 followed by a plasma reaction station 28. However, the deposition device 10 and the method according to the invention is not limited to such an application scenario.

Instead of the plasma reaction station 26, the deposition device 10 can have a second gas processing assembly 30 such that, in step S5, the turntable 12 is rotated such that the substrate 20 is turned through between a second pair of gas processing assemblies 32 and 34. Then, in step S3, instead of igniting a plasma, a second gas is injected from the second pair of gas processing assemblies 32 and 34 into the gas reaction station 26 formed by the second gas processing assembly 30 which reacts with the atomic layer formed on the substrate 20 to obtain the desired type of coating. The second gas typically contains a co-reactant which is different from the precursor injected by the first pair of gas processing assemblies 32 and 34. The gas supply of the second pair of gas processing assemblies 32 and 34 can also be controlled by the control unit 42 based on further valves associated to the second pair of gas processing assemblies 32 and 34. The second gas can be provided from the same gas supplying unit 36 used for supplying the first gas and/or can be provided from a further gas supplying unit. In this variant, a thermal ALD process is realized.

Generally, the process temperatures of a thermal ALD process will be higher than for a plasma-assisted ALD process. E.g., if a thermal ALD process is envisaged, it is especially beneficial if the substrate 20 is heated up to a temperature of up to 500 °C instead of up to 300 °C in plasma-assisted ALD.

In addition, in thermal ALD processes, the gas curtain 68 is especially beneficial to avoid unwanted intermixing of precursor injected by the first pair of gas processing assemblies 32 and 34 and the co-reactant injected by the second pair of gas processing assemblies 32 and 34. Furthermore, the gas used for generation of the gas curtain 68 will typically be an inert gas.

Further, in the sequence discussed above, the deposition device 10 only comprises two processing stations, i.e. the gas reaction station 26 and the plasma reaction station 28 shown in Figs. 1 to 3. However, the deposition device 10 can comprise further processing stations, e.g. several gas reaction stations 26 and several plasma reaction stations 28. That is, the deposition device 10 can comprise a plurality of pairs of gas processing assemblies 32 and 34 and/or a plurality of pairs of plasma electrodes 44 and 46. The respective stations are separated from each other. In case of a thermal ALD process, it is also possible that not all the gas reaction stations are operated at the same time to minimize the gas exchange between the respective gas reaction stations.

E.g., the pairs of gas processing assemblies 32 and 34 can alternate with the pairs of plasma electrodes 44 and 46 in the turntable rotation direction as indicated in Fig. 4.

It is also possible that different pairs of gas processing assemblies 32 and 34 use a different spray pattern, i.e. a different showerhead pattern, than at least one the further gas processing assemblies 32 and 34 to increase coating uniformity, especially in view of different types of coatings to be applied. Thus, the deposition device 10 can comprises a plurality of pairs of gas processing assemblies 32 and 34 with different spray pattern, wherein only those pairs of gas processing assemblies 32 and 34 are used which are optimal for preparing the type of coating in a given run of the deposition device 10.

Fig. 5 shows a further variant of the deposition device 10 which essentially corresponds to the variant discussed before in relation to Figs. 1 and 2 such that only differences will be explained in the following. Same reference numerals denote the same or functionally same components and it is referred to the explanations given above.

In the variant of Fig. 5, a taller and wider substrate 20 is to be coated, wherein the substrate 20 is of generally spherical or elliptical shape. Of course, the shape of the substrate 20 can be different from the specific example shown in Fig.5.

The gas reaction station 26 integrated in the top plate 24 and the bottom plate 22 comprises a second recess 64 adapted to the substrate 20 such that the substrate 20 can be fitted between the top plate 24 and the bottom plate 22 while at the same time minimizing the size of the first gap 57 and of the second gap 58. That is, the second recess 64 is formed in a way that the substrate 20 does not interfere with the rotation of the turntable 12.

The first recess 61 and the second recess 64 can be part of a ring-shaped recess structure formed in the top plate 24 and the bottom plate 22 such to ensure that the substrate 20 can be rotated by the turntable 12 without colliding with the top plate 24 and the bottom plate 22.

Further, the first plasma electrode 44 and the second plasma electrode 46 have a non-planar shape which is adapted to the shape of the substrate 20. E.g., the non-planar shape is a tunnel shape with a curvature in the radial direction. Termed differently, the first plasma electrode 44 and the second plasma electrode 46 are curved such to minimize the size of the third gap 59 and the fourth gap 60 while ensuring that the rotation of the turntable 12 is not hindered. At the same time, the uniformity of the achieved coating can be improved, as the plasma ignited by the plasma electrodes 44 and 46 can more easily cover the whole substrate 20 compared to electrodes with a plane shape as used in the variant of Figs. 1 and 2.

The deposition device 10 can be a part of a system 66 comprising the deposition device 10 and at least two turntables 12, wherein the turntables 12 differ from each other, e.g. in their thickness. In this case, the turntables 12 are mounted within the deposition device 10 in an exchangeable manner such that between different runs of the deposition device, the turntables 12 can be exchanged to ensure that a turntable 12 is used which provides an optimal thickness for the substrates 20 to be coated in the next run.

Changing the turntable thickness to match the substrate height might require adjusting the distance between the turntable 12 and the top plate 24 and the bottom plate 22 to ensure conformal coating on the substrate 20 and minimal gas exchange between the reaction stations.

It is also possible that the system 66 comprises different types of top plates 24 and bottom plates 22 which are mounted in the deposition device 10 in an exchangeable manner, e.g. the different top plates 24 and bottom plates 22 as shown in Fig. 2 and 3, such that also the top plate 24 and the bottom plate 22 used for a respective coating procedure can be chosen in an optimal manner for a given substrate 20 which is to be coated.

In this way, a modular system 66 can be realized which always provides for an optimized s-ALD procedure.

A further option for adapting the application of gases and/or plasma during the formation of the coating on the substrate 20 is the use of a mask which is arranged between the respective showerheads 52 and 56 and the substrate 20 or between the respective plasma electrodes 44 and 46. The mask at least partially blocks certain areas of the substrate 20 from direct exposure of the applied gas or plasma such that the reaction behavior can be further influenced.

Overall, the deposition device of the present invention makes it possible to run efficient s-ALD processes with high deposition rates and providing uniform coatings even on complex substrate geometries.

### Reference numerals

- 10: deposition device
- 12: turntable
- 14: support shaft
- 16: drive
- 18: receptacle
- 20: substrate
- 22: bottom plate
- 24: top plate
- 26: gas reaction station
- 28: plasma reaction station
- 30: gas processing assembly
- 32: first gas processing assembly
- 34: second processing assembly
- 36: supplying unit
- 38: first valve
- 40: second valve
- 42: control unit
- 43: gas outlet port
- 44: first plasma electrode
- 46: second plasma electrode
- 48: power supply
- 50: housing
- 51: center gas showerhead
- 52: first showerhead
- 54: first gas inlet port
- 55: second gas inlet port
- 56: second showerhead
- 57: first gap
- 58: second gap
- 59: third gap
- 60: fourth gap
- 61: recess
- 64: second recess
- 66: modular system
- 68: gas curtain
- 70: heating
- 72: heating element

## Claims

1. A spatial atomic layer deposition device (10) for coating substrates (20), the deposition device (10) comprising
a rotatable turntable (12) having at least one receptacle (18) for a substrate (20), wherein the receptacle (18) extends through the turntable (12) such that a substrate (20) arranged in the receptacle (18) is accessible from above and below,
at least one pair of gas processing assemblies (32, 34), wherein a first gas processing assembly (32) of the pair of gas processing assemblies (32, 34) is arranged above the turntable (12) and a second gas processing assembly (34) of the pair of gas processing assemblies (32, 34) is arranged below the turntable (12) in overlap with the first gas processing assembly (32),
wherein the at least one pair of gas processing assemblies (32, 34) is arranged at the same radial position as the receptacle (18) with respect to a rotation axis of the turntable (12), thereby forming a gas reaction station (26), and
wherein the gas processing assemblies (32, 34) each comprise at least one gas inlet port (54, 55) for exposing the substrate (20) with a gas within the gas reaction station (26).

2. The deposition device (10) according to claim 1, wherein the deposition device (10) comprises at least one pair of plasma electrodes (44, 46), wherein a first plasma electrode (44) of the pair of plasma electrodes (44, 46) is arranged above the turntable (12) and a second plasma electrode (46) of the pair of plasma electrodes (44, 46) is arranged below the turntable (12) in overlap with the first plasma electrode (44).

3. The deposition device (10) according to claim 2, wherein the at least one pair of plasma electrodes (44, 46) is arranged at the same radial position as the receptacle (18) with respect to a rotation axis of the turntable (12), thereby forming a plasma reaction station (28).

4. The deposition device (10) according to claim 2 or 3, wherein the first plasma electrode (44) and the second plasma electrode (46) have a non-planar shape.

5. The deposition device (10) according to any of the preceding claims, wherein the deposition device (10) comprises a plurality of pairs of gas processing assemblies (32, 34) and/or a plurality of pairs of plasma electrodes (44, 46).

6. The deposition device (10) according to claim 5, wherein the pairs of gas processing assemblies (32, 34) are arranged alternating with the pairs of plasma electrodes (44, 46).

7. The deposition device (10) according to claim 5 or 6, wherein at least one pair of gas processing assemblies (32, 34) has a different spray pattern than another pair of gas processing assemblies (32, 34) of the plurality of pairs of gas processing assemblies (32, 34).

8. The deposition device (10) according to any of the preceding claims, wherein the deposition device (10) comprises a control unit (42) which is configured to control a supply of gas, particularly a gas comprising a precursor and/or co-reactant, through the gas processing assemblies (32, 34), wherein the control unit (42) is configured to control a flow of gas based on the gas used.

9. The deposition device (10) according to claim 8, wherein the control unit (42) is configured to control the flow of gas individually for the gas processing assemblies (32, 34), in particular wherein the control unit (42) is configured to control the flow of gas such that different gases are provided to the first gas processing assembly (32) and the second gas processing assembly (34).

10. The deposition device (10) according to any of the preceding claims, wherein the gas processing assemblies (32, 34) each comprise at least one gas outlet port (43) for exhausting a gas from the gas reaction station (26).

11. The deposition device (10) according to any of the preceding claims, wherein the deposition device (10) comprises a bottom plate (22) and a top plate (24), and wherein the first gas processing assembly (32) is integrated in the top plate (24) and the second gas processing assembly (34) is integrated in the bottom plate (22).

12. The deposition device (10) according to any of the preceding claims, wherein the turntable (12) is mounted within the deposition device (10) in an exchangeable manner.

13. The deposition device (10) according to any of the preceding claims, wherein the deposition device (10) comprises a heating.

14. A system (66) with a deposition device (10) according to any of the preceding claims and at least two turntables (12), wherein each of the two turntables (12) differ from each other.

15. A method for coating a substrate (20) in a deposition device (10), particularly the deposition device (10) according to any of the claims 1 to 13, wherein the deposition device (10) comprises a turntable (12) and at least a first pair of gas processing assemblies (32, 34), wherein a first gas processing assembly (32) of the first pair of gas processing assemblies (32, 34) is arranged above the turntable (12) and a second gas processing assembly (34) of the first pair of gas processing assemblies (32, 34) is arranged below the turntable (12) in overlap with the first gas processing assembly (32), wherein the gas processing assemblies (32, 34) together form a gas reaction station (26), and wherein the deposition device (10) comprises a second pair of gas processing assemblies (32, 34) and/or a pair of plasma electrodes (44, 46) in addition to the first pair of gas processing assemblies (32, 34) which is spaced with a distance to the second pair of gas processing assemblies (32, 34) and/or the pair of plasma electrodes (44, 46) in a circumferential direction, the method comprising the following steps.
a) placing a substrate (20) in a receptacle (18) of the turntable (12),
b) rotating the turntable (12) such that the substrate (20) is turned through the gas reaction station (26) associated with the first pair of gas processing assemblies (32, 34),
c) injecting at least a first gas into the gas reaction station (26) from both gas processing assemblies (32, 34) of the first pair of gas processing assemblies (32, 34);
d) rotating the turntable (12) further such that the substrate (20) is turned through between the gas processing assemblies (32, 34) of the second pair of gas processing assemblies (32, 34) or between the plasma electrodes (44, 46) of the pair of plasma electrodes (44, 46); and
e) injecting at least a second gas from the second pair of gas processing assemblies (32, 34) or igniting a plasma by the pair of plasma electrodes (44, 46).
